# EUROPÄISCHE PATENTANMELDUNG

(11) **EP 4 704 261 A1**
(43) Veröffentlichungstag der Anmeldung: **04.03.2026**
(21) Anmeldenummer: 25194291.8
(22) Anmeldetag: 06.08.2025
(51) Int. Cl.: H01R 13/6466, H01R 24/64, H01R 13/66

(54) **ELEKTRISCHER VERBINDER FÜR EIN DATEN- ODER KOMMUNIKATIONSKABEL**

(30) Priorität: 29.08.2024 DE 102024124680
(71) Anmelder: Metz connect GmbH, 78176 Blumberg (DE)
(72) Erfinder: Müller, Hartmut, 78199 Bräunlingen (DE); Merk, Benjamin, 78176 Blumberg (DE); Becker, Eduard, 78056 Weigheim (DE); Pyczak, Andreas, 78247 Hilzingen (DE); Deschle, Marko, 78176 Blumberg (DE)
(74) Vertreter: Westphal, Mussgnug & Partner Patentanwälte mbB

(57) **Zusammenfassung**

Elektrischer Verbinder (1) für ein Daten- oder Kommunikationskabel mit folgenden Merkmalen:
- ein Gehäuse (10),
- eine erste Platine (20), wobei erste und zweite Kontaktelemente (21, 22) mit der ersten Platine (20) unmittelbar elektrisch verbunden sind,
- eine zweite Platine (30),
gekennzeichnet durch die weiteren Merkmale:
- mindestens eine dritte Platine (40),
- die erste, zweite und dritte Platine (20, 30, 40) sind mit mindestens einem zweiten Kontaktelement (22) unmittelbar elektrisch verbunden, und
- die erste, zweite und dritte Platine (20, 30, 40) sind zumindest teilweise in dem Gehäuse angeordnet.

## Beschreibung

Die Erfindung betrifft einen elektrischen Verbinder für ein Daten- oder Kommunikationskabel gemäß den Merkmalen des Patentanspruchs 1.

Bei elektrischen Verbindern, insbesondere bei RJ45-Buchsen oder RJ45-Steckern, ist der Bauraum zumeist begrenzt. Die Größe der Platine des elektrischen Verbinders ist damit ebenfalls limitiert. Eine Anordnung und Ausgestaltung von Kompensationseinheiten innerhalb der Platine um NEXT, FEXT, die Einfügedämpfung und die Reflexionsdämpfung zu verbessern ist daher beschränkt. Häufig wird daher zusätzlich zur Hauptplatine eine Kompensationsplatine eingesetzt. Es hat sich jedoch gezeigt, dass mit zunehmender Datenrate eine einzige Kompensationsplatine nicht mehr ausreicht.

Dieses Problem wird durch einen elektrischen Verbinder für ein Daten- oder Kommunikationskabel mit den Merkmalen des Patentanspruchs 1 gelöst.

Vorteilhafte Ausgestaltungen und Weiterbildungen der Erfindung sind in den abhängigen Ansprüchen angegeben.

Erfindungsgemäß ist demnach ein elektrischer Verbinder für ein Daten- oder Kommunikationskabel, wobei der elektrische Verbinder ein Gehäuse sowie eine erste Platine aufweist. Mit der ersten Platine sind erste und zweite Kontaktelemente unmittelbar elektrisch verbunden. Zudem weist der elektrische Verbinder eine zweite Platine und mindestens eine dritte Platine auf, wobei die erste, zweite und dritte Platine mit mindestens einem zweiten Kontaktelement unmittelbar elektrisch verbunden sind. Zudem sind die erste, zweite und dritte Platine zumindest teilweise in dem Gehäuse angeordnet.

Die vorliegende Erfindung beruht auf der Idee einen elektrischen Verbinder bereitzustellen, der mindestens drei Kompensationsplatinen aufweist, die mit den zweiten Kontaktelementen elektrisch verbunden sind, wobei die zweiten Kontaktelemente eine elektrische Verbindung zu einem komplementären weiteren elektrischen Verbinder bereitstellen. Die Anordnung dreier Platinen innerhalb des elektrischen Verbinders hat den Vorteil, dass mehr Freiheitsgrade zur Verfügung stehen, um das topologiebedingte Übersprechen, insbesondere zwischen den Kontaktelementen zu minimieren oder auszulöschen. Durch geschickte Positionierung der Platinen und Ausgestaltung der Kompensationseinheiten kann das Übersprechen nahezu ausgelöscht werden. Durch die größere Anzahl an Freiheitsgraden ist ebenfalls eine Optimierung der Einfügedämpfung und der Reflexionsdämpfung möglich.

Es versteht sich, dass bei der Betrachtung eines elektrischen Verbinders und deren topologiebedingten Übersprechsignale stets der komplementäre elektrische Verbinder und dessen Einfluss bei der Auslegung eines elektrischen Verbinders mitberücksichtigt werden muss.

Bevorzugterweise bildet der elektrische Verbinder acht galvanisch getrennte Übertragungspfade aus. Ein Übertragungspfad umfasst das erste und zweite Kontaktelement und eine Leiterbahn, wobei die Leiterbahn einen Leitungspfad und ein erstes sowie zweites Kontaktpad aufweist.

In elektrischen Verbindern, insbesondere wenn der elektrische Verbinder als RJ45-Stecker ausgebildet ist, findet die Datenübertragung vorzugsweise auf differentiellen Leitungen oder differentiellen Übertragungspfaden statt. Ein differentieller Übertragungspfad weist einen ersten Übertragungspfad und einen zweiten Übertragungspfad auf. Auf dem ersten Übertragungspfad wird ein Signal übertragen, während der zweite Übertragungspfad das invertierte Signal transmittiert. Der Empfänger bildet die Differenz zwischen den beiden Signalen, wobei die Differenz dem ursprünglichen zu übertragenden Signal entspricht.

Gemäß einer besonders vorteilhaften Ausgestaltung der Erfindung weist der elektrische Verbinder vier differentielle Übertragungspfade auf. Die Übertragungspfade weisen normativ bedingt die Kennzeichnung eins bis acht auf. Die Übertragungspfade eins und zwei, die Übertragungspfade drei und sechs, die Übertragungspfade vier und fünf sowie die Übertragungspfade sieben und acht bilden jeweils einen differentiellen Übertragungspfad auf.

Vorzugsweise ist auf der ersten und/oder zweiten und/oder dritten Platine mindestens eine Kompensationseinheit ausgebildet. Es können auch mehr als eine Kompensationseinheit auf einer der Platinen ausgebildet sein.

Bevorzugterweise ist auf der ersten, zweiten und dritten Platine mindestens eine Kompensationseinheit ausgebildet. Es können auch mehr als eine Kompensationseinheit ausgebildet sein.

Die Kompensationseinheit kann dabei sowohl eine Induktivität als auch eine Kapazität sein.

Die Induktivität kann als diskretes Bauteil oder durch eine mäanderförmige Struktur eines Leitungspfades einer Leiterbahn ausgebildet sein. Es muss dabei hinsichtlich der Eigeninduktivität, welche insbesondere auf die Einfügedämpfung und Rückflussdämpfung einen Einfluss hat, und hinsichtlich des Übersprechens, welches insbesondere auf Streuinduktivitäten zwischen Leiterbahnen und Kontaktelementen zurückzuführen ist, bei der Auslegung aller relevanter Parameter unterschieden werden.

Die Kapazität kann als Kondensator, insbesondere als Plattenkondensator oder als Interdigitalkondensator ausgebildet sein. Dabei kann die Kapazität über eine Stichleitung mit der Leiterbahn elektrisch verbunden sein.

Es versteht sich, dass eine Kapazität stets einen induktiven Anteil aufweist und die Induktivität in Verbindung mit anderen elektrischen Bauteilen und Verbindungen einen kapazitiven Anteil aufweist. Sowohl der kapazitive Anteil als auch der induktive Anteil müssen bei der Kompensation von Übersprechen aber auch hinsichtlich der Einfüge- und Rückflussdämpfung berücksichtigt werden.

Beispielsweise wirken zwei parallel zueinander verlaufende Leiterbahnen, wobei die Leiterbahnen sowohl entlang einer Platinenlage oder entlang unterschiedlicher Platinenlagen parallel verlaufen können, sowohl kapazitiv als auch induktiv aufeinander ein.

Die Kompensationseinheiten können auf den einzelnen Platinen auch zwischen die anderen differentiellen Übertragungspfade geschaltet sein. Beispielsweise kann zwischen den Übertragungspfaden vier und fünf und zwischen den Übertragungspfaden 3 und 6 jeweils auf einer Platine eine oder mehrere Kompensationseinheiten zwischen geschaltet sein, beziehungsweise aufeinander einwirken.

Es können auch mehr als drei Kompensationseinheiten zwischen denselben differentiellen Übertragungspfad geschaltet werden. Beispielsweise können vier, fünf oder sechs Kompensationseinheiten zwischen einen differentiellen Übertragungspfad geschaltet werden. Dabei weist die erste und/oder die zweite und/oder die dritte Platine mehr als eine Kompensationseinheit auf. Die Kompensationseinheiten können dabei als Induktivitäten oder als Kapazitäten ausgebildet sein.

Durch geschickte Anordnung der ersten, zweiten und dritten Platine, kann das Übertragungsverhalten hinsichtlich Übersprechen, Einfüge- und Reflexionsdämpfung deutlich verbessert werden. Durch die unterschiedliche Positionierung der ersten, zweiten und dritten Platinen können die induktiven und kapazitiven Anteile und wo sie entlang der Übertragungsstrecke wirken variiert und optimiert werden. Dies ist insbesondere bei der Verbesserung der Einfüge- und Reflexionsdämpfung von Vorteil.

Gemäß einer besonders bevorzugten Ausgestaltung der Erfindung weist die erste Platine eine erste Kompensationseinheit auf. Die erste Kompensationseinheit ist zwischen die Übertragungspfade eines differentiellen Übertragungspfades geschaltet.

Die zweite Platine weist eine zweite Kompensationseinheit auf, welche vorzugsweise zwischen dieselben Übertragungspfade geschaltet ist. Die dritte Platine weist eine dritte Kompensationseinheit auf, die zwischen dieselben Übertragungspfade geschaltet ist. Beispielsweise ist die erste, zweite und dritte Kompensationseinheit zwischen die Übertragungspfade vier und sechs geschaltet. Vorteilhafterweise sind alle drei Kompensationseinheiten als Kondensatoren, insbesondere als Plattenkondensatoren, ausgebildet.

In einer anderen vorteilhaften Ausgestaltung der Erfindung ist die erste Kompensationseinheit als Induktivität und die zweite und dritte Kompensationseinheit als Kapazität ausgebildet. Die Induktivität ist dabei vorteilhafterweise als mäanderförmiger Leitungspfad ausgebildet. Beide Leistungspfade des Übertragungspfades des differentiellen Übertagungspfades können einen solchen mäanderförmigen Verlauf aufweisen. Damit ergibt sich eine Induktivität-Kondensator-Kondensator-Kombination. Die Induktivität kann auch auf der zweiten oder dritten Platine angeordnet sein.

Vorteilhafterweise werden die erste, zweite und dritte Kompensationseinheit, die auf der jeweiligen Platine ausgebildet sind, zur Reduzierung des Übersprechens verwendet. Zwischen zwei benachbarten Übertragungspfaden unterschiedlicher differentieller Übertragungspfade kommt es zu Übersprechen. Dieses Übersprechen wird ausgelöscht, indem eine Kompensationseinheit zwischen einem der benachbarten Übertragungspfade auf den Übertragungspfadzwilling des anderen benachbarten Übertragungspfades einwirkt. Beispielsweise findet ein Übersprechen zwischen den Übertragungspfaden drei und vier statt. Sodann wird eine Kompensationseinheit zwischen die Übertragungspfade drei und fünf geschaltet. Eine solche Kompensationseinheit kann beispielsweise auf der ersten Platine und/oder zweiten Platine und/oder dritten Platine angeordnet sein.

Es kann auch eine solche Kompensationseinheit auf der ersten Platine angeordnet sein. Auf der zweiten Platine kann eine Kompensationseinheit angeordnet sein, die gleich wie das Übersprechen wirkt. Also wie im vorherigen Beispiel zwischen drei und vier angeordnet ist. Die dritte Kompensationseinheit kann gleich wie die Kompensationseinheit auf der ersten Platine oder gleich wie die Kompensationseinheit auf der zweiten Platine angeordnet sein. Ziel ist es, die Kompensationseinheiten derart anzuordnen und auszubilden, dass sich das Übersprechen auslöscht. Das Übersprechen soll sich bestenfalls über einen weiten Frequenzbereich auslöschen. Die Kompensationseinheiten können auf den drei Platinen beliebig zwischen den drei Übertragungspfaden angeordnet werden, um das Übersprechen zu reduzieren.

In einer vorteilhaften Weiterbildung der Erfindung ist die dritte Platine in der Nähe eines freien Endes der zweiten Kontaktelemente angeordnet. Es hat sich als vorteilhaft erwiesen, wenn die Kompensation so nahe wie möglich am Ort des ungewollten Übersprechens angeordnet ist. Durch das Anordnen der dritten Platine im Bereich eines freien Endes der zweiten Kontaktelemente ist die dritte Platine nahe am widrigen Übersprechen angeordnet.

Die dritte Platine ist vorzugsweise nahe der Kontaktstelle angeordnet, wobei die Kontaktstelle diejenige Stelle des zweiten Kontaktelements ist, die eine elektrische Verbindung zwischen dem elektrischen Verbinder und einem komplementären elektrischen Verbinder herstellt.

Bevorzugterweise ist die zweite Platine entlang einer elektrischen Verbindung nahe an der Kontaktstelle angeordnet. Bevorzugterweise ist die zweite und dritte Platine entlang einer elektrischen Verbindung maximal 10 % der Gesamtlänge der zweiten Kontaktelemente von der Kontaktstelle entfernt angeordnet.

In einer vorteilhaften Weiterbildung der Erfindung sind die zweite und dritte Platine, insbesondere deren Kompensationseinheiten der jeweiligen Platine, entlang einer elektrischen Verbindung gleich weit zu der Kontaktstelle angeordnet.

Gemäß einer bevorzugten Ausgestaltung der Erfindung ist die dritte Platine entlang einer elektrischen Verbindung näher an einer Kontaktstelle, die den elektrischen Verbinder mit einem komplementären Verbinder verbindet, angeordnet als die zweite Platine.

Gemäß einer bevorzugten Ausgestaltung der Erfindung verlaufen die erste und dritte Platine zumindest annähernd parallel zueinander, wobei die zweite Platine zumindest annähernd senkrecht zur ersten und dritten Platine angeordnet ist. Dadurch ist eine möglichst kompakte Anordnung gewährleistet. Auch das Anordnen und Verbauen der Platinen ist einfach zu bewerkstelligen.

Die Platinen können auch einen Winkel zueinander aufweisen. Die erste und zweite Platine können einen Winkel zwischen 0 und 90 Grad, vorzugweise einen Winkel zwischen 10 und 80 Grad, ganz besonders bevorzugt einen Winkel zwischen 35 und 55 Grad aufweisen. Selbiges gilt für jede mögliche Anordnung zwischen der ersten, zweiten und dritten Platine.

Nach einer besonders vorteilhaften Ausgestaltung der Erfindung findet eine Datenübertragung über einen Übertragungspfad statt, wobei der Übertragungspfad eine Leiterbahn, ein erstes und ein zweites Kontaktelement umfasst, wobei die erste Platine die Leiterbahnen aufweist, wobei jede Leiterbahn ein erstes Kontaktelement mit einem zweiten Kontaktelement elektrisch verbindet.

Eine Leiterbahn weist bevorzugterweise einen Leitungspfad sowie ein erstes Kontaktpad und ein zweites Kontaktpad. Das erste Kontaktpad ist mit dem ersten Kontaktelement unmittelbar elektrisch verbunden und das zweite Kontaktpad ist mit dem zweiten Kontaktelement unmittelbar elektrisch verbunden.

Vorteilhafterweise weist die erste Platine acht Leiterbahnen auf, wobei eine differentielle Leitung durch jeweils eine erste und eine zweite Leiterbahn ausgebildet wird. Die Leiterbahnen sind Bestandteil des Übertragungspfades.

Die erste Platine weist vorteilhafterweise Kompensationseinheiten auf, die in der Nähe der zweiten Kontaktpads angeordnet sind. Vorteilhafterweise sind die Kompensationseinheiten über Stichleitungen mit den zweiten Kontaktpads oder direkt mit den zweiten Kontaktpads elektrisch verbunden.

Gemäß einer weiteren vorteilhaften Ausgestaltung der Erfindung sind Kompensationseinheiten im Bereich der ersten Kontaktpads, die die ersten Kontaktelemente, welche bevorzugterweise als Schneidklemmen ausgebildet sind, mit der ersten Platine elektrisch verbinden, angeordnet.

Bevorzugterweise ist die erste Platine und/oder zweite Platine und/oder dritte Platine als flexible Platine ausgebildet. Es können auch alle drei Platinen zumindest abschnittsweise als flexible Platine ausgebildet sein. Flexible Platinen haben den Vorteil, dass diese an die Gegebenheiten innerhalb eines Gehäuses flexibel anpassbar sind und dadurch Platzersparnisse mit sich bringen. In einer Ausführungsvariante ist allerdings die erste Platine als starre, nicht flexible Platine ausgebildet.

Die erste, zweite und dritte Platine können, insbesondere wenn sie als flexible Platinen ausgeführt sind, sehr dünn ausgebildet sein. Vorzugsweise ist die Substrathöhe der flexiblen Platinen zwischen 30 und 400 µm groß.

Nach einer besonders vorteilhaften Ausgestaltung der Erfindung ist die zweite und/oder dritte Leiterplatte aus einem Substrat mit einer Substrathöhe von weniger als oder gleich 100 µm, vorzugsweise weniger als oder gleich 25 µm, ausgebildet.

Vorteilhafterweise sind die flexiblen Platinen zweilagig ausgebildet. Die flexiblen Platinen können auch mehr als zweilagig ausgebildet sein, beispielsweise kann die flexible Platine 4, 6 oder 8 Lagen aufweisen. Es liegt auch im Rahmen der Erfindung, starre oder Star-Flex-Platinen zu verwenden. Auch die starren oder Starr-Flex-Platinen können einlagig, zweilagig, vierlagig, sechslagig oder mehrlagig ausgebildet sein.

Vorteilhafterweise ist die zweite Platine als flexible Platine ausgebildet. Die zweite Platine kann auch starr ausgebildet sein. Die zweite Platine weist Kompensationseinheiten, insbesondere Kapazitäten, auf. Die zweite Platine weist Kontaktierungspads auf, die die zweite Platine mit den zweiten Kontaktelementen elektrisch verbinden.

Vorteilhafterweise sind die Kompensationseinheiten der zweiten Platine zwischen die Übertragungspfade eines differentiellen Übertragungspfades geschaltet. In einer solchen Anordnung werden die Kompensationseinheiten verwendet, um eine Anpassung der Leitungsimpedanz vorzunehmen, um insbesondere die Parameter Einfügedämpfung und Reflexionsdämpfung zu verbessern. Auch die Kompensationseinheiten der ersten und/oder dritten Platine können die Kompensationseinheiten zwischen die Übertragungspfade eines differentiellen Übertragungspfades schalten. Beispielsweise kann eine Kapazität zwischen die Übertragungspfade drei und sechs geschaltet sein und eine Induktivität zwischen die Übertragungspfade vier und fünf geschaltet sein. Es kann auch zwischen einem Übertragungspfad mehr als eine Kompensationseinheit auf der ersten, zweiten oder dritten Platine geschaltet sein.

In einer weiteren vorteilhaften Weiterbildung der Erfindung weist die zweite Platine Kompensationseinheiten auf, die zwischen zwei Übertragungspfade unterschiedlicher differentieller Übertragungspfade geschaltet ist. Auch die erste und die dritte Platine können Kompensationseinheiten aufweisen, die zwei Übertragungspfade unterschiedlicher differentieller Übertragungspfade wirken. Damit wird insbesondere eine Reduzierung des NEXT und FEXT vorgenommen.

Bevorzugterweise weist die dritte Platine Finger auf. Die Finger sind durch am Rand sich in Richtung der Platine erstreckende Schlitze ausgebildet. Die Finger sind gegeneinander verbiegbar. Die Finger weisen Kontaktierungsstellen auf. Die Kontaktierungsstellen sind vorteilhafterweise in Form von elektrisch leitenden Flächen auf einer der äußeren Platinenlagen der dritten Platine angeordnet.

Die dritte Leiterplatte weist Kompensationseinheiten, insbesondere Kondensatoren, insbesondere Plattenkondensatoren, auf. Besonders bevorzugt ist, dass die dritte Leiterplatte sehr dünn ausgebildet ist. Dadurch sind die Platten eines Plattenkondensators nahe zueinander beabstandet angeordnet. Dadurch können Kompensationseinheiten in ihrer Fläche klein ausgebildet sein. Selbiges gilt selbstverständlich auch für die erste und zweite Platine.

In einer vorteilhaften Weiterbildung der Erfindung ist die zweite und/oder dritte Platine mit vier oder acht zweiten Kontaktelementen verbunden. Insbesondere tritt zwischen den mittleren vier Leiterbahnen und insbesondere deren Kontaktelementen verstärkt Übersprechen auf, weswegen sich die Anordnung einer dritten Platine empfiehlt.

Die zweiten Kontaktelemente sind vorzugsweise als Steckkontakte ausgebildet. Die zweiten Kontaktelemente weisen eine Kontaktstelle auf, wobei die Kontaktstelle diejenige Stelle ist, die eine elektrische Verbindung mit einem komplementären Stecker herstellt. Die zweiten Kontaktelemente sind im Steckgesicht des elektrischen Verbinders angeordnet. Die zweiten Kontaktelemente erstrecken sich entlang der Längsachse des elektrischen Verbinders und verlaufen zumeist parallel zueinander. Bevorzugterweise weisen die zweiten Kontaktelemente Kreuzungen auf, wobei sich aus einer Draufsicht betrachtet die Reihenfolge der zweiten Kontaktelemente ändert. Die zweiten Kontaktelemente sind vorzugsweise federnd ausgebildet. Das hat den Vorteil, dass die elektrische Verbindung mit den Kontaktierungsstellen der Platinen und mit dem komplementären elektrischen Verbinder besser ist. Die zweiten Kontaktelemente können zudem einen bogenförmigen Verlauf aufweisen. Dadurch ist es möglich den elektrischen Verbinder äußerst kompakt auszubilden.

Die ersten Kontaktelemente sind bevorzugterweise als Schneidklemmen ausgebildet. Schneidklemmen haben den Vorteil, dass sie beim Zusammensetzten des elektrischen Verbinders, die in das Ladestück eingesetzten Leitungsadern automatisch abisolieren und zwischen Kabel und elektrischen Verbinder eine elektrische Verbindung herstellen. Die ersten Kontaktelemente können auch als Stifte ausgebildet sein.

Gemäß einer vorteilhaften Ausgestaltung der Erfindung bilden die erste, zweite und dritte Platine jeweils eine Kompensationseinheit aus, wobei diese Kompensationseinheiten mit demselben differentiellen Übertragungspfad verbunden sind.

Bevorzugterweise bilden die erste, zweite und dritte Platine jeweils mindestens eine Kompensationseinheit aus, wobei eine dieser Kompensationseinheiten zwischen Übertragungspfade eines differentiellen Übertragungspfades geschaltet ist und eine der Kompensationseinheiten zwischen Übertragungspfade unterschiedlicher differentieller Übertragungspfade geschaltet ist.

Vorteilhafterweise sind alle zweiten Kontaktelemente mit der ersten, zweiten und dritten Platine elektrisch verbunden.

Vorzugsweise ist der elektrische Verbinder als Buchse, insbesondere als RJ45-Buchse ausgebildet.

Es versteht sich, dass die Anordnung und Ausgestaltung der Kompensationseinheiten sowie die Anordnung der ersten bis dritten Platine innerhalb der Buchse nur unter Berücksichtigung des komplementären RJ45-Steckers stattfinden kann. Das Übersprechen, das im RJ45-Stecker stattfindet, ist im Vorherigen hier und im Folgenden berücksichtigt, durch das Übersprechen an der Kontaktstelle der RJ45-Buchse.

Nachfolgend wird unter Bezugnahme auf die begleitenden Zeichnungen ein Ausführungsbeispiel der vorliegenden Erfindung im Detail beschrieben. Es zeigt:
- Fig. 1: eine perspektivische Ansicht einer Explosionsdarstellung eines elektrischen Verbinders,
- Fig. 2: eine perspektivische Ansicht einer Baugruppe des elektrischen Verbinders aus Fig. 1, aufweisend eine erste und zweite Platine, ein Trägerelement sowie zweite Kontaktelemente,
- Fig. 3: eine perspektivische Ansicht einer Explosionsdarstellung der Baugruppe aus Fig. 2,
- Fig. 4: eine perspektivische Ansicht der dritten Platine aus den Figuren 1 bis 3.

Gleiche oder funktional gleiche Teile oder Merkmale werden in der nachfolgenden detaillierten Beschreibung der Figuren mit den gleichen Bezugszeichen gekennzeichnet. Ebenso sind in den Figuren alle gleichen oder funktional gleichen Teile oder Merkmale mit einer Bezugsziffer versehen.

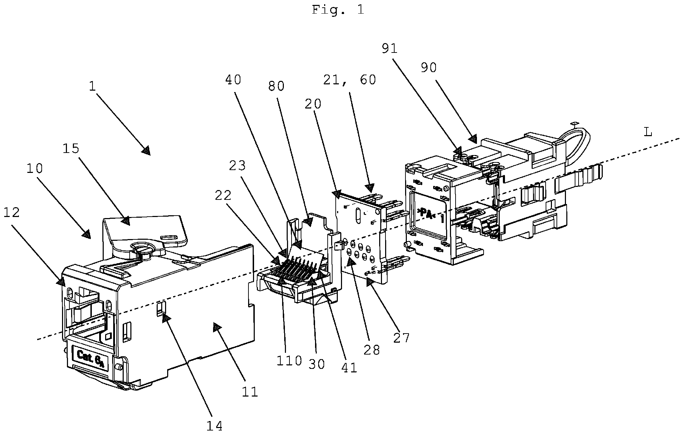

In Fig. 1 ist ein elektrischer Verbinder 1 in Explosionsdarstellung gezeigt. Der elektrische Verbinder 1 ist als Buchse, insbesondere als RJ45-Buchse, ausgebildet.

Der elektrische Verbinder 1 umfasst ein Gehäuse 10, ein Trägerelement 80, eine erste Platine 20, eine zweite Platine 30 und eine dritte Platine 40, erste Kontaktelemente 21 und zweite Kontaktelemente 22 sowie ein Ladestück 90.

Das Gehäuse 10 weist ein Gehäusevorderteil 11 und ein Gehäusehinterteil 15 auf. Das Gehäusehinterteil 15 ist schwenkbar an dem Gehäusevorderteil 11 angeordnet. Das Gehäusevorderteil 11 weist an einer Stirnseite 12 ein Steckgesicht auf. Durch das Steckgesicht ist ein komplementärer elektrischer Verbinder (nicht gezeigt) in den elektrischen Verbinder 1 einführbar.

Das Gehäuse 10 ist vorzugsweise aus einem elektrisch leitenden Material. Dies hat den Vorteil, dass die Elektronik im elektrischen Verbinder 1 besser vor elektromagnetischer Strahlung (EMV) geschützt ist und auch andere elektrische Komponenten in der Nähe des elektrischen Verbinders weniger EMV ausgesetzt sind. Das Gehäuse 10 kann auch aus einem Kunststoffgehäuse oder zumindest teilweise aus Kunststoff ausgebildet sein.

Das Gehäusevorderteil 11 weist jeweils an seinen Seitenflächen 13 Ausnehmungen 14 auf.

Das Trägerelement 80 weist an seinen Seitenflächen 81 jeweils eine Nut 82 auf, welche in die jeweilige Ausnehmung 14 des Gehäusevorderteils 11 greift und das Trägerelement 80 mit dem Gehäusevorderteil 11 mechanisch verbindet. Das Trägerelement 80 ist vorzugsweise aus einem Kunststoff ausgebildet.

Das Trägerelement 80 weist einen L-förmigen Querschnitt auf, welcher in zwei senkrecht zueinander angeordnete Bereiche 83, 84 unterteilbar ist. Einer dieser Bereiche 83 erstreckt sich parallel zur Längsachse L. Der parallel zur Längsachse L des elektrischen Verbinders 1 angeordnete Bereich 83 sind die zweiten Kontaktelemente 21 vornehmlich eingelegt. Dieser Bereich 83 bildet zudem eine Aufnahme 85 aus, in welche die zweite Platine 30 eingelegt ist.

Im Bereich des freien Endes 23 der zweiten Kontaktelemente 22 ist die dritte Platine 40 mit den zweiten Kontaktelementen 22 elektrisch und mechanisch verbunden. Die dritte Platine 40 weist Finger 41 auf. Die Finger 41 bilden jeweils eine Kontaktierungsstelle 42 aus. Die zweiten Kontaktelemente 22 werden jeweils mit einer Kontaktierungsstelle 42 der dritten Platine 40 verlötet, sodass sich eine mechanische und elektrische Verbindung einstellt. Die dritte Platine 40 wird ausschließlich über die Kontaktierungsstellen 42 innerhalb des elektrischen Verbinders 1 fixiert. Die dritte Platine 40 ist vorzugsweise als flexible dritte Platine 40 ausgebildet. Die dritte Platine 40 kann auch als starre oder zumindest teilweise starre Platine ausgebildet sein.

Parallel zum Bereich 84 des Trägerelements 80, der nicht parallel zur Längsachse L des elektrischen Verbinders 1 sich erstreckt, ist die erste Platine 20 angeordnet.

Die erste Platine 20 weist erste Kontaktpads 27 und zweite Kontaktpads 28 auf, die zur elektrischen und mechanischen Verbindung der ersten Kontaktelemente 21 und zweiten Kontaktelemente 22 verwendet werden. Die Kontaktpads 27, 28 sind vorzugsweise kreisförmig um ein Loch in der ersten Platine 20 angeordnet.

Die erste Platine 20 ist vorzugsweise als starre Platine ausgebildet. Dadurch übernimmt die erste Platine 20 einen Anteil an der mechanischen Stabilität des elektrischen Verbinders 1. Zudem ist die Montierung der ersten und zweiten Kontaktelemente 21, 22 durch die mechanische Stabilität der ersten Platine 10 einfacher. Die erste Platine 10 kann auch als Star-Flex-Platine ausgebildet sein. Bei einer Star-Flex-Platine ist ein Teil der Platine flexibel. Die erste Platine 20 kann auch als flexible erste Platine 20 ausgebildet sein.

Die erste Platine 20 kann senkrecht oder parallel zur zweiten Platine 30 angeordnet sein.

Die erste Platine 20 kann senkrecht oder parallel zur dritten Platine 40 angeordnet sein.

Die zweite Platine 30 kann senkrecht oder parallel zur dritten Platine 40 angeordnet sein.

Die dritte Platine 40 kann in einem Winkel zur ersten Platine 20 und/oder zweiten Platine 30 angeordnet sein. Die zweite Platine 30 kann in einem Winkel zur ersten Platine 20 angeordnet sein.

Die dritte Platine 40 kann einen Winkel zwischen 10 und 80 Grad, vorzugsweise zwischen 15 und 50 Grad, ganz besonders bevorzugt zwischen 20 und 30 Grad gegenüber der ersten Platine 20 aufweisen.

Die dritte Platine 40 kann einen Winkel zwischen 10 und 80 Grad, vorzugsweise zwischen 15 und 50 Grad, ganz besonders bevorzugt zwischen 20 und 30 Grad gegenüber der zweiten Platine 30 aufweisen.

Die zweite Platine 30 kann einen Winkel zwischen 10 und 80 Grad, vorzugsweise zwischen 15 und 50 Grad, ganz besonders bevorzugt zwischen 20 und 30 Grad gegenüber der ersten Platine 20 aufweisen.

Die erste Platine 20 und/oder die zweite Platine 30 und/oder die dritte Platine 40 kann/können parallel und/oder senkrecht zur Längsachse L des elektrischen Verbinders 1 angeordnet sein.

Die erste Platine 20 ist entlang einer elektrischen Verbindung weiter entfernt zu der Kontaktstelle 70 angeordnet als die zweite oder dritte Platine 30, 40. Die erste Platine 20 ist entlang einer elektrischen Verbindung mindestens 10 %, besonders bevorzugt mindestens 30 %, ganz besonders bevorzugt mindestens 80 % weiter entfernt angeordnet als die zweite oder dritte Platine 30, 40.

Der elektrische Verbinder 1 bildet acht Übertragungspfade 110 aus. Ein Übertragungspfad 110 umfasst das erste und zweite Kontaktelement 21, 22 und eine Leiterbahn, wobei die Leiterbahn einen Leitungspfad und ein erstes sowie zweites Kontaktpad 27, 28 aufweist. Ein differentieller Übertragungspfad wird durch zwei Übertragungspfade 110 ausgebildet.

Die ersten Kontaktelemente 21 sind vorzugsweise als Schneidklemmen 60 ausgebildet. Die Schneidklemmen 60 weisen einen Fuß auf, der beim Montieren des elektrischen Verbinders 1 durch ein Loch in der ersten Platine 20 geschoben wird, um anschließend durch eine Lötverbindung mit der ersten Platine 20 mechanisch und elektrisch verbunden zu werden. Es können aber auch die Schneidklemmen 60 per Press-Fit in die Leiterplatte bzw. Platine in dort vorgesehene Öffnungen eingepresst werden.

Die zweiten Kontaktelemente 22 erstrecken sich bevorzugterweise parallel zur Längsachse L des elektrischen Verbinders 1. Die zweiten Kontaktelemente 22 sind stabförmig ausgebildet, wobei das zweite Kontaktelement 22 mindestens einen zumindest abschnittsweisen kurvenförmigen Verlauf aufweist.

Die zweiten Kontaktelemente 22 weisen in der Nähe des freien Endes 23 eine Kontaktstelle 70 auf. Die Kontaktstelle ist diejenige Stelle die den elektrischen Verbinder 1 mit einem komplementären elektrischen Verbinder (nicht gezeigt) elektrisch verbindet.

Im Bereich des elektrischen Verbinders 1, in welchen ein Kabel (nicht zu sehen) in den elektrischen Verbinder 1 eingeführt wird, ist ein Ladestück 90 angeordnet. Das Ladestück 90 ist vorzugsweise aus Kunststoff ausgebildet.

Das Ladestück 90 weist Ausbuchtungen 91 auf, in welche die Einzeladern eines Kabels (nicht zu sehen) eingelegt werden. Beim Fertigmonieren isolieren die ersten Kontaktelemente 21, welche vorzugsweise als Schneidklemmen 60 ausgebildet sind, die Isolierung der Einzeladern ab und stellen eine elektrische Verbindung zwischen Einzelader und Schneidklemme 60 her. Die Schneidklemmen 60 greifen dabei in die Ausbuchtungen 91 des Ladestücks 90 ein.

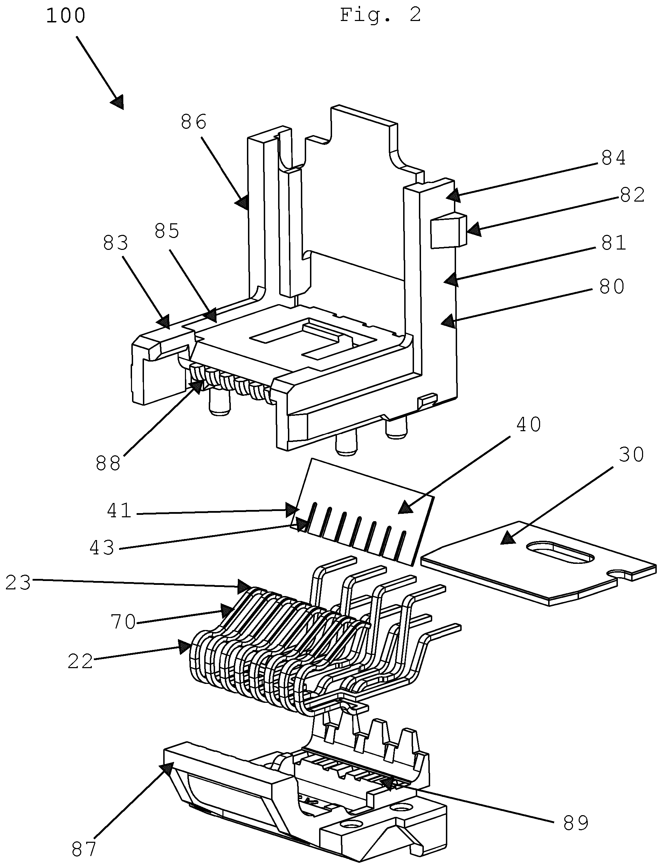

Fig. 2 zeigt eine perspektivische Explosionsdarstellung einer Baugruppe 100, wobei die Baugruppe 100 das Trägerelement 80, die zweiten Kontaktelemente 21 sowie die zweite und dritte Platine 30, 40 umfasst.

Das Trägerelement 80 ist zweiteilig ausgebildet. Das Trägerelement 80 weist ein Oberteil 86 und ein Unterteil 87 auf. Das Unterteil 87 des Trägerelements 80 weist Einkerbungen 89 auf, in welche Erhöhung des Oberteils 86 greifen. Das Oberteil 86 des Trägerelements 80 weist ebenfalls Einkerbungen 88 auf.

Im Zusammengesetzten Zustand bilden die Einkerbungen 89 des Unterteils 87 und die Einkerbungen 88 des Oberteils 86 des Trägerelements 80 einen Kanal aus, in welchen jeweils ein zweites Kontaktelement 22 eingelegt und zumindest in einer Raumrichtung mechanisch fixiert ist. Die zweiten Kontaktelemente 22 können auch in dem Kanal mechanisch in allen drei Raumrichtungen fixiert werden, in dem das jeweilige zweite Kontaktelement 22 verklemmt wird.

Das Trägerelement 80 bildet vorzugsweise eine Aufnahme 85 aus, in welche die zweite Platine 30 eingelegt ist.

Die zweiten Kontaktelemente 22 können in mehrere Bereiche unterteil werden. Ein Bereich kann parallel zur Längsachse L des elektrischen Verbinders 1 verlaufen und eine elektrische Verbindung mit der ersten Platine 20 über die zweiten Kontaktpads 28 herstellen.

Zudem können die zweiten Kontaktelemente 22 einen Kreuzungsbereich 95 aufweisen. In dem Kreuzungsbereich 95 werden die zweiten Kontaktelemente 22 aus einer Draufsicht ausgesehen in ihrer Reihenfolge verändert.

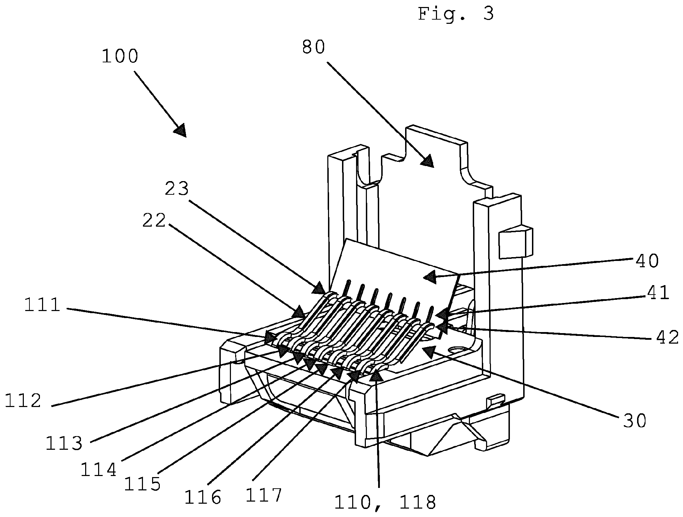

Fig. 3 zeigt eine perspektivische Ansicht der zusammengesetzten Baugruppe 100 aus Fig. 2.

Die zweite Platine 30 ist in die Aufnahme 85 des Trägerelements 80 eingelegt. Die zweiten Kontaktelemente 22 sind federnd ausgebildet. Die zweite Platine 30 weist Kontaktpads auf. Die zweiten Kontaktelemente 22 kontaktieren mit den Kontaktpads der zweiten Platine 30 und spannen aufgrund ihrer federnden Ausgestaltung die zweite Platine 30 auf dem Trägerelement 80 fest.

Die dritte Platine 40 ist mit ihren Fingern 41 und den darauf befindlichen Kontaktierungsstellen 42 im Bereich der freien Enden 23 der zweiten Kontaktelemente 22 mit den zweiten Kontaktelementen 22 elektrisch verbunden.

Es kann auch noch eine vierte, fünfte oder sechste Platine (oder noch mehr Platinen) mit den zweiten Kontaktelementen 22 elektrisch und/oder mechanisch verbunden sein. Die zweiten Kontaktelemente 22 sind vorzugsweise mit jeder der verbauten Platinen elektrisch verbunden.

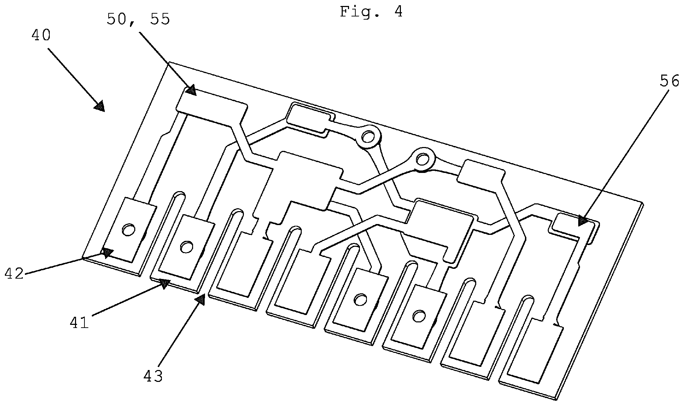

Fig. 4 zeigt eine perspektivische Ansicht der dritten Platine 40.

Die dritte Platine 40 weist sechs Kompensationseinheiten 50 auf. Die Kompensationseinheiten 50 sind als Plattenkondensatoren 55 ausgebildet. Die Plattenkondensatoren 55 können auch als Interdigitalkondensatoren ausgebildet sein. Die Kompensationseinheiten 50 können auch als Induktivitäten 52 ausgebildet sein.

Die dritte Platine 40 weist Finger 41 auf. Die Finger 41 sind durch Schlitze 43, die ausgehend von einer Längskante 44 der dritten Platine 40 in Richtung Platinenmitte sich erstrecken, ausgebildet.

Die Kontaktierungsstellen 42, die die dritte Platine 40 mit den zweiten Kontaktelementen 22 elektrisch kontaktieren, sind padförmig ausgebildet. Die Kontaktierungsstellen 42 sind im Bereich der Finger 41 ausgebildet.

Bevorzugterweise weist der elektrische Verbinder acht galvanisch oder elektrisch voneinander getrennte Übertragungspfade eins bis acht 111-118 auf. Die Übertragungspfade eins und zwei 111, 112, die Übertragungspfade drei und sechs 113, 116, die Übertragungspfade vier und fünf 114, 115 und die Übertragungspfade sieben und acht 117, 118 bilden jeweils einen differentiellen Übertragungspfad aus.

Die Plattenkondensatoren 55 weisen jeweils zwei sich gegenüberstehende Platten 56 auf, wobei die Platten 56 sich nicht vollständig überlappen. Die Platten 56 der Plattenkondensatoren 55 können sich auch vollständig überlappen.

Die Kontaktierungsstelle 42 in Fig. 4, welche auf der linken Seite der dritten Platine 40 angeordnet ist, ist Teil des Übertragungspfades acht 118 oder ist mit dem Übertragungspfad acht 118 elektrisch verbunden. Die Kontaktierungsstelle 42 in Fig. 4, welche auf der linken Seite der dritten Platine angeordnet ist, ist Teil des Übertragungspfades acht 111 oder ist mit dem Übertragungspfad eins 111 elektrisch verbunden. Die Kontaktierungsstellen 42 dazwischen sind fortlaufend mit den Übertragungspfaden 112-117 zwei bis sieben elektrisch verbunden.

Die Platten 56 der Plattenkondensatoren 55 sind mit den Übertragungspfaden eins und drei 111, 113, mit den Übertragungspfaden drei und sieben 113, 117, mit den Übertragungspfaden zwei und sechs 112, 116, mit den Übertragungspfaden vier und sechs 114, 116, mit den Übertragungspfaden sechs und acht 116, 118 und mit den Übertragungspfaden drei und fünf 113, 115 elektrisch verbunden.

Die Platten 56 der Plattenkondensatoren 55 sind damit stets zwischen zwei Übertragungspfade 110 unterschiedlicher differentieller Übertragungspfade geschaltet.

Die Plattenkondensatoren 55 werden in diesem Ausführungsbeispiel primär zur Reduzierung von Übersprechen verwendet.

Die Platten 56 der Plattenkondensatoren 55 können auch zwischen die Übertragungspfade 110 eines differentiellen Übertragungspfades geschaltet sein.

### Bezugszeichenliste

- 1: Elektrischer Verbinder
- 10: Gehäuse
- 11: Gehäusevorderteil
- 12: Stirnseite
- 13: Seitenfläche
- 14: Ausnehmungen
- 15: Gehäusehinterteil

- 20: Erste Platine
- 21: Erste Kontaktelemente
- 22: Zweite Kontaktelemente
- 23: Freies Ende
- 25: Differentieller Übertragungspfad

- 27: Erstes Kontaktpad
- 28: Zweites Kontaktpad
- 30: Zweite Platine

- 40: Dritte Platine
- 41: Finger
- 42: Kontaktierungsstellen
- 43: Schlitze
- 44: Längskante

- 50: Kompensationseinheit
- 51: Kondensator
- 52: Induktivität
- 55: Plattenkondensator
- 56: Platten

- 60: Schneidklemmen

- 70: Kontaktstelle

- 80: Trägerelement
- 81: Seitenfläche
- 82: Nut
- 83: Bereich
- 84: Bereich
- 85: Aufnahme
- 86: Oberteil
- 87: Unterteil
- 88: Einkerbungen
- 89: Einkerbungen

- 90: Ladestück
- 91: Ausbuchtung

- 100: Baugruppe

- 110: Übertragungspfad
- 111: Übertragungspfad eins
- 112: Übertragungspfad zwei
- 113: Übertragungspfad drei
- 114: Übertragungspfad vier
- 115: Übertragungspfad fünf
- 116: Übertragungspfad sechs
- 117: Übertragungspfad siebe
- 118: Übertragungspfad acht

- L: Längsachse

## Patentansprüche

1. Elektrischer Verbinder (1) für ein Daten- oder Kommunikationskabel mit folgenden Merkmalen:
- ein Gehäuse (10),
- eine erste Platine (20), wobei erste und zweite Kontaktelemente (21, 22) mit der ersten Platine (20) unmittelbar elektrisch verbunden sind,
- eine zweite Platine (30),
**gekennzeichnet durch** die weiteren Merkmale:
- mindestens eine dritte Platine (40),
- die erste, zweite und dritte Platine (20, 30, 40) sind mit mindestens einem zweiten Kontaktelement (22) unmittelbar elektrisch verbunden, und
- die erste, zweite und dritte Platine (20, 30, 40) sind zumindest teilweise in dem Gehäuse angeordnet.

2. Elektrischer Verbinder (1) nach Anspruch 1, **dadurch gekennzeichnet, dass** auf der ersten und/oder zweiten und/oder dritten Platine (20, 30, 40) mindestens eine Kompensationseinheit (50) ausgebildet ist.

3. Elektrischer Verbinder (1) nach einem der vorherigen Ansprüche, **dadurch gekennzeichnet, dass** auf der ersten, zweiten und dritten Platine mindestens eine Kompensationseinheit (50) ausgebildet ist.

4. Elektrischer Verbinder (1) nach einem der vorherigen Ansprüche, **dadurch gekennzeichnet, dass** die dritte Platine (40) in der Nähe eines freien Endes (23) der zweiten Kontaktelemente (22) angeordnet ist.

5. Elektrischer Verbinder (1) nach einem der vorherigen Ansprüche, **dadurch gekennzeichnet, dass** die erste und dritte Platine (20, 40) zumindest annähernd parallel zueinander verlaufen, wobei die zweite Platine (30) zumindest annähernd senkrecht zur ersten und dritten Platine (20, 40) angeordnet ist.

6. Elektrischer Verbinder (1), nach einem der vorherigen Ansprüche, **dadurch gekennzeichnet, dass** eine Datenübertragung über einen Übertragungspfad (110) stattfindet, wobei der Übertragungspfad (110) eine Leiterbahn, ein erstes und ein zweites Kontaktelement (21, 22) umfasst, wobei die erste Platine (20) die Leiterbahnen aufweist, wobei jede Leiterbahn ein erstes Kontaktelement (21) mit einem zweiten Kontaktelement (22) elektrisch verbindet.

7. Elektrischer Verbinder (1) nach einem der vorherigen Ansprüche, **dadurch gekennzeichnet, dass** die erste Platine (20) und/oder zweite Platine (30) und/oder dritte Platine (40) und/oder weiteren Platinen als flexible Leiterplatte ausgebildet ist.

8. Elektrischer Verbinder (1) nach einem der vorherigen Ansprüche, **dadurch gekennzeichnet, dass** die zweite und/oder dritte Platine (30, 40) mit vier oder acht zweiten Kontaktelementen (22) verbunden ist.

9. Elektrischer Verbinder (1) nach einem der vorherigen Ansprüche, **dadurch gekennzeichnet, dass** die dritte Platine (40) entlang einer elektrischen Verbindung näher an einer Kontaktstelle (70), die den elektrischen Verbinder (1) mit einem komplementären Verbinder verbindet, angeordnet ist als die zweite Platine (30).

10. Elektrischer Verbinder (1) nach einem der vorherigen Ansprüche, **dadurch gekennzeichnet, dass** die zweite und/oder dritte Platine (30, 40) aus einem Substrat ausgebildet ist, wobei die Substrathöhe kleiner gleich 100 µm, vorzugsweise kleiner gleich 25 µm, ausgebildet ist.

11. Elektrischer Verbinder (1) nach einem der vorherigen Ansprüche, **dadurch gekennzeichnet, dass** die erste, zweite und dritte Platine (20, 30, 40) jeweils eine Kompensationseinheit (50) ausbilden, wobei diese Kompensationseinheiten (50) mit demselben differentiellen Übertragungspfad verbunden sind.

12. Elektrischer Verbinder (1) nach einem der vorherigen Ansprüche, **dadurch gekennzeichnet, dass** die erste, zweite und dritte Platine (20, 30, 40) jeweils mindestens eine Kompensationseinheit (50) ausbilden, wobei einer dieser Kompensationseinheiten (50) zwischen Übertragungspfade (110) eines differentiellen Übertragungspfades geschaltet ist und einer der Kompensationseinheiten (50) zwischen Übertragungspfade (110) unterschiedlicher differentieller Übertragungspfade geschaltet ist.

13. Elektrischer Verbinder (1) nach einem der vorherigen Ansprüche, **dadurch gekennzeichnet, dass** der elektrische Verbinder (1) als Buchse, insbesondere als RJ45-Buchse ausgebildet ist.
